# EUROPEAN PATENT APPLICATION

(11) **EP 4 716 392 A1**
(43) Date of publication of application: **25.03.2026**
(21) Application number: 24932998.8
(22) Date of filing: 02.12.2024
(51) Int. Cl.: H05K 7/20

(54) **CIRCULATING LIQUID SUPPLY SYSTEM FOR LIQUID COOLING AND CIRCULATING LIQUID SUPPLY METHOD FOR LIQUID COOLING**

(30) Priority: 29.03.2024 CN 202410376228
(71) Applicant: Suzhou Metabrain Intelligent Technology Co., Ltd., Suzhou, Jiangsu 215000 (CN)
(72) Inventor: ZHANG, Xiaowei, Suzhou, Jiangsu 215000 (CN); LIU, Guangzhi, Suzhou, Jiangsu 215000 (CN)
(74) Representative: Studio Torta S.p.A.
(86) International application number: PCT/CN2024/136172
(87) International publication number: WO 2025/200541

(57) **Abstract**

The present invention provides a circulating liquid supply system for liquid cooling and a circulating liquid supply method for liquid cooling. The circulating liquid supply system for liquid cooling comprises: a basic circulating liquid supply device comprising a heat exchanger and a circulation pump which are communicated through a pipe; a negative-pressure circulating liquid supply device comprising a liquid tank and a negative-pressure generation component which are communicated through a pipe; and a switching assembly. The circulating liquid supply system for liquid cooling has a basic circulation mode and a negative-pressure circulation mode; in the basic circulation mode, the circulation pump drives a cooling liquid to perform circulating heat exchange between a position to be cooled and the heat exchanger under a positive pressure along the pipe; and in the negative-pressure circulation mode, the negative-pressure generation component drives the cooling liquid to perform circulating heat exchange between said position and the heat exchanger under a negative pressure along the pipe. According to the present invention, the basic circulating liquid supply device can be used independently as a conventional positive-pressure CDU, and can also be used in combination with the negative-pressure circulating liquid supply device to be used as a negative-pressure CDU.

## Description

### Cross-Reference to Related Application

The present invention claims priority and the benefit of Chinese Patent Application No. 202410376228.4, filed with the China National Intellectual Property Administration (CNIPA) on 29 March 2024, and entitled "Liquid-Cooled Circulating Liquid Supply System and Liquid-Cooled Circulating Liquid Supply Method", which is herein incorporated by reference in its entirety.

### Technical Field

The present invention relates to the technical field of liquid cooling devices, and in particular to a liquid-cooled circulating liquid supply system and a liquid-cooled circulating liquid supply method.

### Background

With the exponential growth of chip power consumption, traditional air-cooled technology has reached its cost-effective heat dissipation limit. Liquid cooling technology, which can solve the heat dissipation problem of higher heat flux density and has higher energy efficiency, has emerged and has developed vigorously in recent years. At present, the commonly used chip-level liquid cooling technologies include two types: immersion liquid cooling and cold plate liquid cooling. The immersion liquid cooling method is used on a smaller scale due to its high cost and difficult maintenance. In the cold plate liquid cooling method, a pump is used to drive the coolant (water, ethylene glycol, etc.) to flow through a flow channel on the back of a chip, the coolant exchanges heat with the chip through a plate wall in the channel to remove heat from the chip, thereby achieving an object of heat dissipation. The cold plate liquid cooling method has the advantages of mature technology, energy saving and noise reduction, and is therefore widely used.

In a relevant cold plate liquid cooling system, a CDU (Coolant Distribution Unit) is a core power unit, and is used to achieve functions including driving, stabilizing the pressure, and automatically distributing the heat exchange medium within a cooling loop of a liquid cooling system. As a power unit, the CDU drives the coolant (i.e., the heat exchange medium) to circulate within the system. Currently, the conventional CDU is mainly driven by a circulation pump, and the system is under a positive pressure (i.e., the air pressure inside the system is greater than the external atmospheric pressure). Therefore, when a rupture or loosening occurs somewhere in the system, the coolant will leak and other problems may occur. The currently widely used coolant such as water and propylene glycol aqueous solution is conductive, and once leaked, the coolant will cause fatal damage to a server. Therefore, certain technical means are used such that the pressure inside the system is maintained below the external atmospheric pressure, that is, a negative pressure system is created to address the above leakage problem. In this way, the coolant will not leak into the server and other positions, but external air will enter the system, making a cooling system safer. In summary, the cooling system that generates a negative pressure has broad application prospects.

The negative pressure cooling system in related technologies usually has many internal components and a complex structure, which makes component maintenance extremely difficult during actual use. Moreover, only a vacuum pump is used to provide a constant suction force to regulate the liquid supply pressure and flow, which has many limitations during actual use. In addition, if a component fails, the entire system will not be able to operate, and the system reliability is relatively poor.

### Summary

The present invention provides a liquid-cooled circulating liquid supply system and a liquid-cooled circulating liquid supply method, to solve the problems of poor working stability and easy leakage of coolant in the liquid cooling system in the related art.

In order to solve the above problems, some embodiments of the present invention provide a liquid-cooled circulating liquid supply system, including: a basic circulating liquid supply device, and the basic circulating liquid supply device includes a heat exchanger and a circulation pump communicated through a pipeline; a negative pressure circulating liquid supply device, and the negative pressure circulating liquid supply device includes a liquid tank and a negative pressure generating assembly communicated through a pipeline, and the negative pressure generating assembly is configured to regulate the pressure in an accommodating chamber inside the liquid tank to a negative pressure; a switching assembly, and the switching assembly is configured to control a connection and disconnection between the basic circulating liquid supply device and the negative pressure circulating liquid supply device; wherein the liquid-cooled circulating liquid supply system has a basic circulation mode and a negative pressure circulation mode; in the basic circulation mode, the switching assembly disconnects a communication between the basic circulating liquid supply device and the negative pressure circulating liquid supply device, and the circulation pump drives a coolant to circulate and exchange heat under a positive pressure along a pipeline between a position to be cooled and the heat exchanger; in the negative pressure circulation mode, the switching assembly establishes the communication between the basic circulating liquid supply device and the negative pressure circulating liquid supply device, and the negative pressure generating assembly drives the coolant to circulate and exchange heat under a negative pressure along the pipeline between the position to be cooled and the heat exchanger.

In some embodiments, in the negative pressure circulation mode, the negative pressure generating assembly and the circulation pump simultaneously drive the coolant to circulate and exchange heat under the negative pressure along the pipeline between the position to be cooled and the heat exchanger.

In some embodiments, two liquid tanks are provided, namely, a first liquid tank and a second liquid tank; the first liquid tank and the second liquid tank are respectively in communication with the negative pressure generating assembly through the pipeline; and a reciprocating flow of the coolant is controlled by controlling the changes in a pressure in the first liquid tank and a pressure in the second liquid tank.

In some embodiments, the pressure in the first liquid tank is a first negative pressure, and the pressure in the second liquid tank is a second negative pressure; in response to a liquid level height in the first liquid tank not exceeding a set height, the first negative pressure is less than the second negative pressure, and the second negative pressure is less than or equal to an external air pressure; the heat exchanger and the position to be cooled are in communication between the first liquid tank and the second liquid tank through pipelines; and the coolant enters the first liquid tank from the second liquid tank through a pressure difference between the first negative pressure and the second negative pressure.

In some embodiments, the negative pressure circulating liquid supply device further includes a liquid level gauge, and the liquid level gauge is configured to detect a liquid level height of the coolant in the accommodating chamber; in response to the liquid level gauge detecting that the liquid level height in the first liquid tank exceeds the set height, the first negative pressure is controlled to be greater than the second negative pressure, and the first negative pressure is controlled to be less than or equal to the external air pressure, and the coolant enters the second liquid tank from the first liquid tank.

In some embodiments, the switching assembly includes a first switch valve, a second switch valve, a third switch valve, a fourth switch valve and a fifth switch valve; the first switch valve is disposed in a circulation pipeline in the basic circulating liquid supply device and is configured to control the a connection and disconnection of the circulation pipeline of the basic circulating liquid supply device; the negative pressure circulating liquid supply device further includes a first input pipe, a first output pipe, a second input pipe and a second output pipe; one end of the first input pipe and one end of the first output pipe are respectively in communication with the first liquid tank; the second switch valve is disposed in the first input pipe; the third switch valve is disposed in the first output pipe; one end of the second input pipe and one end of the second output pipe are respectively in communication with the second liquid tank; the fourth switch valve is disposed in the second input pipe, and the fifth switch valve is disposed in the second output pipe; the other end of the first input pipe and the other end of the second input pipe are respectively in communication with a pipeline at one end of the first switch valve, and the other end of the first output pipe and the other end of the second output pipe are respectively in communication with a pipeline at the other end of the first switch valve; wherein in the basic circulation mode, the second switch valve, the third switch valve, the fourth switch valve and the fifth switch valve are all in a closed state, and the first switch valve is open, and the communication between the basic circulating liquid supply device and the negative pressure circulating liquid supply device is disconnected.

In some embodiments, in the negative pressure circulation mode, the first negative pressure is less than the second negative pressure, and the second negative pressure is less than or equal to the external air pressure; the second switch valve and the fifth switch valve are in an open state, and the first switch valve, the third switch valve and the fourth switch valve are in a closed state; the coolant enters the pipeline at the other end of the first switch valve from the second liquid tank and the second output pipe, and passes through the heat exchanger, the position to be cooled, the pipeline at one end of the first switch valve and the first input pipe in sequence and enters the first liquid tank; or, in the negative pressure circulation mode, the first negative pressure is greater than the second negative pressure, and the first negative pressure is less than or equal to the external air pressure; the third switch valve and the fourth switch valve are in an open state, and the first switch valve, the second switch valve and the fifth switch valve are in a closed state; the coolant enters the pipeline at the other end of the first switch valve from the first liquid tank and the first output pipe, and passes through the heat exchanger, the position to be cooled, the pipeline at one end of the first switch valve and the second input pipe in sequence and enters the second liquid tank.

In some embodiments, the negative pressure circulating liquid supply device further includes a first communication valve and a second communication valve, one end of the first communication valve is in communication with the accommodating chamber of the first liquid tank through a pipeline, and the other end thereof is in communication with an external atmosphere; one end of the second communication valve is in communication with the accommodating chamber of the second liquid tank through a pipeline, and the other end thereof is in communication with the external atmosphere; and the negative pressure generating assembly is respectively in communication with the accommodating chamber of the first liquid tank and the accommodating chamber of the second liquid tank in an on-off manner.

In some embodiments, the basic circulating liquid supply device further includes: a filter, an outlet pressure sensor, an outlet temperature sensor, a first solenoid valve, a first flow valve, a bypass branch, a second solenoid valve and a second flow valve; an outlet of the heat exchanger, the circulation pump, the filter, the first flow valve, the outlet temperature sensor, the outlet pressure sensor, the first solenoid valve and an inlet of the position to be cooled are in communication in sequence through a pipeline; the outlet pressure sensor is configured to detect a pressure of the coolant at an outlet of the pipeline to obtain an outlet pressure; the first solenoid valve is configured to control a connection and disconnection of the pipeline of the basic circulating liquid supply device, and the first flow valve is configured to regulate a flow of the pipeline of the basic circulating liquid supply device; the bypass branch is disposed in parallel with the position to be cooled and is configured to shunt the position to be cooled; the second solenoid valve and the second flow valve are disposed in the bypass branch in sequence, the second solenoid valve is configured to control a connection and disconnection of the bypass branch, and the second flow valve is configured to regulate a flow of the bypass branch; and an outlet of the position to be cooled is in communication with the switching assembly and an inlet of the heat exchanger through a pipeline, and the coolant to circulate flows circularly.

In some embodiments, the heat exchanger is internally provided with a basic circulation pipeline and a circulating heat exchange pipeline disposed at intervals, and the basic circulation pipeline is in communication with the circulation pump; the liquid-cooled circulating liquid supply system further includes a circulating heat exchange device, the circulating heat exchange device includes a heat exchange source configured to exchange heat with an external environment, an on-off valve configured to control a connection and disconnection of a pipeline, a circulation filter, a first circulation temperature sensor and a second circulation temperature sensor; one end of the heat exchange source, the first circulation temperature sensor, the on-off valve, and one end of the circulating heat exchange pipeline are in communication in sequence through a pipeline; the other end of the circulating heat exchange pipeline, the circulation filter, the second circulation temperature sensor, and the other end of the heat exchange source are in communication in sequence through a pipeline; and the heat exchange source exchanges heat with the basic circulation pipeline through the circulating heat exchange pipeline.

In some embodiments, the liquid-cooled circulating liquid supply system further includes a central control terminal and an altitude sensor configured to detect an altitude of a position of the negative pressure circulating liquid supply device; the altitude sensor is electrically connected to the central control terminal; and the central control terminal calculates an external ambient atmospheric pressure based on the altitude detected by the altitude sensor; the liquid-cooled circulating liquid supply system further includes an alarm and an outlet pressure sensor, wherein the alarm is electrically connected to the central control terminal and is configured to issue an alarm message; the outlet pressure sensor is disposed at an outlet of the pipeline and is electrically connected to the central control terminal; the outlet pressure sensor is configured to detect an outlet pressure; the circulation pump and the negative pressure generating assembly are electrically connected to the central control terminal respectively; and the central control terminal controls the circulation pump and the negative pressure generating assembly to operate in coordination based on the outlet pressure, the calculated external ambient atmospheric pressure and a set outlet pressure value.

Some other embodiments of the present invention provide a liquid-cooled circulating liquid supply method. The liquid-cooled circulating liquid supply method is applied to the above liquid-cooled circulating liquid supply system; and the liquid-cooled circulating liquid supply method includes: a basic circulating liquid supply step: using the circulation pump to drive the coolant to circulate and exchange heat under the positive pressure between the position to be cooled and the heat exchanger; and a negative pressure circulating liquid supply step: using the negative pressure generating assembly and/or the circulation pump to drive the coolant to circulate and exchange heat under the negative pressure along the pipeline between the position to be cooled and the heat exchanger.

In some embodiments, two liquid tanks are provided, namely, a first liquid tank and a second liquid tank; the first liquid tank and the second liquid tank are respectively in communication with the negative pressure generating assembly through a pipeline; a pressure in the first liquid tank is a first negative pressure, and a pressure in the second liquid tank is a second negative pressure; the negative pressure circulating liquid supply step further includes a negative pressure switching step: first controlling the first negative pressure to be less than the second negative pressure, and controlling the second negative pressure to be less than or equal to an external air pressure, such that the coolant enters the first liquid tank from the second liquid tank; detecting a liquid level height in the first liquid tank, and in response to the liquid level height exceeding a set height, controlling the first negative pressure to be greater than the second negative pressure, and controlling the first negative pressure to be less than or equal to the external air pressure, such that the coolant enters the second liquid tank from the first liquid tank.

In some embodiments, the external air pressure Po is calculated by the following calculation formula: Po=P0* [1-(0.0065*H)/288.15] ^{5.255}, wherein P0 is a standard atmospheric pressure, and H is an altitude of a position of the negative pressure circulating liquid supply device.

In some embodiments, the liquid-cooled circulating liquid supply method further includes a hydraulic control step: detecting a pressure of the coolant at an outlet of the pipeline to obtain an outlet pressure, comparing the outlet pressure with a set outlet pressure value, and controlling the circulation pump and/or the negative pressure generating assembly to operate in coordination to regulate the outlet pressure.

In some embodiments, the hydraulic control step includes a self-adjusting correction factor control step and a closed-loop control step: comparing the outlet pressure with the set outlet pressure value, calculating to obtain an actual error, in response to an absolute value of the actual error being greater than a first error, performing the self-adjusting correction factor control step to regulate the outlet pressure; and in response to the absolute value of the actual error being less than the first error and greater than a second error, performing the closed-loop control step to regulate the outlet pressure.

In some embodiments, the self-adjusting correction factor control step includes: in response to | E | > Eb, setting U = -Ku [αE+(1-α) EC] , and regulating powers of the circulation pump and/or the negative pressure generating assembly based on a magnitude of U; wherein E is the actual error, Eb is the first error, Ku is a proportional coefficient, α = (αₛ-α₀) | E | /N+α₀, 0<α₀<α<αₛ<1, and a domain of E, EC and U is set to (-N, ..., -1, 0, 1, ..., N), N = 20.

In some embodiments, the closed-loop control step includes: in response to Ea < | E | < Eb, setting U = Kp [e(k)-e(k-1)] +Ki e(k)+Kd [e(k)-2e(k-1)+e (k-2)], and regulating powers of the circulation pump and/or the negative pressure generating assembly base on a magnitude of U; wherein Ea is the second error, E is the actual error, Eb is the first error, Kp is a proportional coefficient, Ki is an integral coefficient, Kd is a differential coefficient, and e(k) is the actual error at a k-th sampling.

In some embodiments, the hydraulic control step further includes a repetition step: in response to the absolute value of the actual error being equal to the first error or less than or equal to the second error, and a previous step of the repetition step being the self-adjusting correction factor control step or the closed-loop control step, repeating the step before the repetition step to regulate the outlet pressure; in response to the self-adjusting correction factor control step and the closed-loop control step being not performed before the repetition step, maintaining a current state.

In some embodiments, in response to the previous step of the repetition step being the self-adjusting correction factor control step or the closed-loop control step, and | E | = Eb or | E | ≤Ea, setting U = u0, wherein Ea is the second error, E is the actual error, Eb is the first error, and u0 is the self-adjusting correction factor control step or the closed-loop control step before the repetition step.

In some embodiments, the liquid-cooled circulating liquid supply method further includes a fault control step: in response to a fault being detected in the negative pressure circulating liquid supply device, issuing an alarm message, and switching the liquid-cooled circulating liquid supply system to operate in the basic circulation mode; in response to a fault being detected in the circulation pump in the basic circulating liquid supply device, issuing the alarm message, and switching the liquid-cooled circulating liquid supply system to operate in the negative pressure circulation mode.

Applying the technical solution of the present invention, the present invention provides a liquid-cooled circulating liquid supply system, including: a basic circulating liquid supply device, and the basic circulating liquid supply device includes a heat exchanger and a circulation pump communicated through a pipeline; a negative pressure circulating liquid supply device, and the negative pressure circulating liquid supply device includes a liquid tank and a negative pressure generating assembly communicated through a pipeline, and the negative pressure generating assembly is configured to regulate a pressure in an accommodating chamber inside the liquid tank to a negative pressure; a switching assembly, and the switching assembly is configured to control a connection and disconnection between the basic circulating liquid supply device and the negative pressure circulating liquid supply device; wherein the liquid-cooled circulating liquid supply system has a basic circulation mode and a negative pressure circulation mode, in the basic circulation mode, the switching assembly disconnects a communication between the basic circulating liquid supply device and the negative pressure circulating liquid supply device, and the circulation pump drives the coolant to circulate and exchange heat under a positive pressure along a pipeline between a position to be cooled and the heat exchanger; in the negative pressure circulation mode, the switching assembly establishes the communication between the basic circulating liquid supply device and the negative pressure circulating liquid supply device, and the negative pressure generating assembly drives the coolant to circulate and exchange heat under a negative pressure along the pipeline between the position to be cooled and the heat exchanger.

The present invention creates a combined liquid-cooled circulating liquid supply system by arranging the basic circulating liquid supply device and the negative pressure circulating liquid supply device to operate in coordination. In the present invention, by a switching assembly, the basic circulating liquid supply device may be used alone as a conventional positive pressure CDU, or the basic circulating liquid supply device and the negative pressure circulating liquid supply device may be used in coordination as a negative pressure CDU; the basic circulating liquid supply device and the negative pressure circulating liquid supply device may be maintained separately. The system complexity of the present invention is low, and the maintenance difficulty is greatly reduced. When one of the basic circulating liquid supply device and the negative pressure circulating liquid supply device fails, the liquid-cooled circulating liquid supply system may still operate normally, thereby improving the operating reliability of the system. The present invention may greatly reduce the difficulty of system maintenance and installation deployment, reduce operation and maintenance costs, and be suitable for large-scale promotion and use. The liquid-cooled circulating liquid supply system provided in the present invention may subsequently be combined with a related liquid-cooled circulating liquid supply method, which may not only effectively solve the problem that the related negative pressure liquid cooling system is usually unable to regulate the pressure, but also improve the dynamic response speed of the system to the coolant outlet pressure by adopting a self-adjusting correction factor control step and a closed-loop control step. The liquid-cooled circulating liquid supply system has good use effect and high safety, and may effectively avoid the problem of coolant leakage.

### Brief Description of the Drawings

The drawings that constitute part of the present invention are used to provide a further understanding of the present invention. The embodiments of the present invention and their descriptions are used to explain the present invention and do not constitute an improper limitation on the present invention. In the drawings:

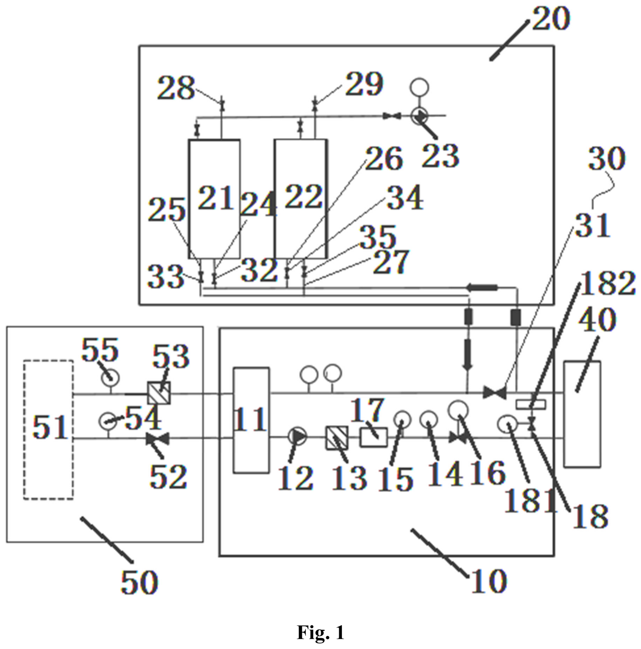

Fig. 1 is a structural schematic diagram of a liquid-cooled circulating liquid supply system according to an embodiment of the present invention.

The above drawings include the following reference numerals:
10. basic circulating liquid supply device; 11. heat exchanger; 12. circulation pump; 13. filter; 14. outlet pressure sensor; 15. outlet temperature sensor; 16. first solenoid valve; 17. first flow valve; 18. bypass branch; 181. second solenoid valve; 182. second flow valve; 20. negative pressure circulating liquid supply device; 21. first liquid tank; 22. second liquid tank; 23. negative pressure generating assembly; 24. first input pipe; 25. first output pipe; 26. second input pipe; 27. second output pipe; 28. first communication valve; 29. second communication valve; 30. switching assembly; 31. first switch valve; 32. second switch valve; 33. third switch valve; 34. fourth switch valve; 35. fifth switch valve; 40. position to be cooled; 50. circulating heat exchange device; 51. heat exchange source; 52. on-off valve; 53. circulation filter; 54. first circulation temperature sensor; 55. second circulation temperature sensor.

### Detailed Description of the Embodiments

The technical solutions in the embodiments of the present invention will be clearly and completely described below in conjunction with the drawings in the embodiments of the present invention. Obviously, the described embodiments are merely part but not all of the embodiments of the present invention. The following description of at least one exemplary embodiment is actually only illustrative and is in no way intended to limit the present invention and its application or use. Based on the embodiments in the present invention, all the other embodiments obtained by those skilled in the art without any creative effort shall fall within the protection scope of the present invention.

As shown in Fig. 1, some embodiments of the present invention provide a liquid-cooled circulating liquid supply system, including: a basic circulating liquid supply device 10, and the basic circulating liquid supply device 10 includes a heat exchanger 11 and a circulation pump 12 communicated through a pipeline; a negative pressure circulating liquid supply device 20, and the negative pressure circulating liquid supply device 20 includes a liquid tank and a negative pressure generating assembly 23 communicated through a pipeline, wherein the negative pressure generating assembly 23 is configured to regulate a pressure in an accommodating chamber inside the liquid tank to a negative pressure; a switching assembly 30, and the switching assembly 30 is configured to control a connection and disconnection between the basic circulating liquid supply device 10 and the negative pressure circulating liquid supply device 20; wherein the liquid-cooled circulating liquid supply system has a basic circulation mode and a negative pressure circulation mode. In the basic circulation mode, the switching assembly 30 disconnects a communication between the basic circulating liquid supply device 10 and the negative pressure circulating liquid supply device 20, and the circulation pump 12 drives a coolant to circulate and exchange heat under a positive pressure along a pipeline between a position 40 to be cooled and the heat exchanger 11; in the negative pressure circulation mode, the switching assembly 30 establishes the communication between the basic circulating liquid supply device 10 and the negative pressure circulating liquid supply device 20, and the negative pressure generating assembly 23 drives the coolant to circulate and exchange heat under a negative pressure along the pipeline between the position 40 to be cooled and the heat exchanger 11.

The present invention creates a combined liquid-cooled circulating liquid supply system by arranging the basic circulating liquid supply device 10 and the negative pressure circulating liquid supply device 20 to operate in coordination. In the present invention, by the switching assembly 30, the basic circulating liquid supply device 10 may be used alone as a conventional positive pressure CDU, or the basic circulating liquid supply device 10 and the negative pressure circulating liquid supply device 20 may be used in coordination as a negative pressure CDU; the basic circulating liquid supply device 10 and the negative pressure circulating liquid supply device 20 may be maintained separately. A system complexity of the present invention is low, and a maintenance difficulty is greatly reduced. When one of the basic circulating liquid supply device 10 and the negative pressure circulating liquid supply device 20 fails, the liquid-cooled circulating liquid supply system may still operate normally, thereby improving an operating reliability of the system. The present invention may greatly reduce a difficulty of system maintenance and installation deployment, reduce operation and maintenance costs, and be suitable for large-scale promotion and use. The liquid-cooled circulating liquid supply system provided in the present invention may subsequently be combined with a related liquid-cooled circulating liquid supply method, which may not only effectively solve the problem that related negative pressure liquid cooling system is usually unable to regulate the pressure, but also improve a dynamic response speed of the system to a coolant outlet pressure by adopting a self-adjusting correction factor control step and a closed-loop control step. The liquid-cooled circulating liquid supply system has good use effect and high safety, and may effectively avoid the problem of coolant leakage.

It should be noted that the switching assembly 30 is respectively in communication with the basic circulating liquid supply device 10 and the negative pressure circulating liquid supply device 20 through a pipeline; and the circulation pump 12 is configured to drive the coolant to circulate and exchange heat along the pipeline.

As shown in Fig. 1, in the negative pressure circulation mode, the negative pressure generating assembly 23 and the circulation pump 12 simultaneously drive the coolant to circulate and exchange heat under the negative pressure along the pipeline between the position 40 to be cooled and the heat exchanger 11.

It should be noted that when the liquid-cooled circulating liquid supply system provided in the present invention is used as a negative pressure system (i.e., in the negative pressure circulation mode), a pressure difference generated by the negative pressure generating assembly 23 in the negative pressure circulating liquid supply device 20 also needs to be partially used to overcome a flow resistance of the heat exchanger 11, the filter 13 and other components in the basic circulating liquid supply device 10. In the present invention, the negative pressure generating assembly 23 and the circulation pump 12 are disposed to simultaneously drive the coolant to circulate and exchange heat under the negative pressure along the pipeline between the position 40 to be cooled and the heat exchanger 11, thereby effectively utilizing the circulation pump 12 in the basic circulating liquid supply device 10 to assist in overcoming the above flow resistance, and ensuring a smooth flow of the coolant in the negative pressure circulation mode.

In an embodiment of the present invention, the negative pressure generating assembly 23 may use an existing air pump to save costs.

As shown in Fig. 1, two liquid tanks are provided, namely, a first liquid tank 21 and a second liquid tank 22. The first liquid tank 21 and the second liquid tank 22 are respectively in communication with the negative pressure generating assembly 23 through the pipeline. A reciprocating flow of the coolant is controlled by controlling changes in a pressure in the first liquid tank 21 and a pressure in the second liquid tank 22. By arranging the first liquid tank 21 and the second liquid tank 22, a pressure differential design for the negative pressure system is achieved by a simple structure, and reliable operation of the negative pressure circulating liquid supply device 20 is ensured.

In the embodiment, a pressure in the first liquid tank 21 is a first negative pressure, and a pressure in the second liquid tank 22 is a second negative pressure; in response to the liquid level height in the first liquid tank 21 not exceeding a set height, the first negative pressure is less than the second negative pressure, and the second negative pressure is less than or equal to the external air pressure; the heat exchanger 11 and the position 40 to be cooled are in communication between the first liquid tank 21 and the second liquid tank 22 through pipelines, and the coolant enters the first liquid tank 21 from the second liquid tank 22 through a pressure difference between the first negative pressure and the second negative pressure.

In an embodiment, the negative pressure circulating liquid supply device 20 further includes a liquid level gauge, and the liquid level gauge is configured to detect a liquid level height of the coolant in the accommodating chamber; in response to the liquid level gauge detecting that the liquid level height in the first liquid tank 21 exceeds the set height, the first negative pressure is controlled to be greater than the second negative pressure, and the first negative pressure is controlled to be less than or equal to the external air pressure, such that the coolant enters the second liquid tank 22 from the first liquid tank 21. By arranging the liquid level gauge and controlling relative changes of the first negative pressure and the second negative pressure, reciprocating circulation of the coolant between the first liquid tank 21 and the second liquid tank 22 is achieved.

As shown in Fig. 1, the switching assembly 30 includes a first switch valve 31, a second switch valve 32, a third switch valve 33, a fourth switch valve 34 and a fifth switch valve 35; the first switch valve 31 is disposed in a circulation pipeline in the basic circulating liquid supply device 10 and is configured to control a connection and disconnection of the circulation pipeline of the basic circulating liquid supply device 10; the negative pressure circulating liquid supply device 20 further includes a first input pipe 24, a first output pipe 25, a second input pipe 26 and a second output pipe 27; one end of the first input pipe 24 and one end of the first output pipe 25 are respectively in communication with the first liquid tank 21; the second switch valve 32 is disposed in the first input pipe 24; the third switch valve 33 is disposed in the first output pipe 25; one end of the second input pipe 26 and one end of the second output pipe 27 are respectively in communication with the second liquid tank 22, the fourth switch valve 34 is disposed in the second input pipe 26, and the fifth switch valve 35 is disposed in the second output pipe 27; the other end of the first input pipe 24 and the other end of the second input pipe 26 are respectively in communication with a pipeline at one end of the first switch valve 31, and the other end of the first output pipe 25 and the other end of the second output pipe 27 are respectively in communication with a pipeline at the other end of the first switch valve 31; wherein in the basic circulation mode, the second switch valve 32, the third switch valve 33, the fourth switch valve 34 and the fifth switch valve 35 are all in a closed state, and the first switch valve 31 is open, and the communication between the basic circulating liquid supply device 10 and the negative pressure circulating liquid supply device 20 is disconnected.

Through the above design, the flow of each pipeline is effectively controlled, and a switching function of the switching assembly 30 is achieved with a simple structure.

As shown in Fig. 1, in the negative pressure circulation mode, the first negative pressure is less than the second negative pressure, and the second negative pressure is less than or equal to the external air pressure, the second switch valve 32 and the fifth switch valve 35 are in an open state, and the first switch valve 31, the third switch valve 33 and the fourth switch valve 34 are in a closed state; the coolant enters the pipeline at the other end of the first switch valve 31 from the second liquid tank 22 and the second output pipe 27, and passes through the heat exchanger 11, the position 40 to be cooled, the pipeline at one end of the first switch valve 31 and the first input pipe 24 and enters the first liquid tank 21; or, in the negative pressure circulation mode, the first negative pressure is greater than the second negative pressure, and the first negative pressure is less than or equal to the external air pressure, the third switch valve 33 and the fourth switch valve 34 are in an open state, and the first switch valve 31, the second switch valve 32 and the fifth switch valve 35 are in a closed state; the coolant enters the pipeline at the other end of the first switch valve 31 from the first liquid tank 21 and the first output pipe 25, and passes through the heat exchanger 11, the position 40 to be cooled, the pipeline at one end of the first switch valve 31 and the second input pipe 26 in sequence and enters the second liquid tank 22.

Through such an arrangement, in the negative pressure circulation mode, regardless of whether the coolant flows from the first liquid tank 21 to the second liquid tank 22 or flows from the second liquid tank 22 to the first liquid tank 21, a flow direction of the coolant in the circulation pipeline of the basic circulating liquid supply device 10 remains unchanged; for example: as shown in Fig. 1, the coolant flows from a left side to a right side of the circulation pump 12, thereby ensuring that the circulation pump 12 always does useful work on the flow of the coolant when the circulation pump 12 is operating, and helping the coolant to overcome the flow resistance of components such as the heat exchanger 11 and the filter 13.

As shown in Fig. 1, the negative pressure circulating liquid supply device 20 further includes a first communication valve 28 and a second communication valve 29, one end of the first communication valve 28 is in communication with the accommodating chamber of the first liquid tank 21 through a pipeline, and the other end thereof is in communication with the external atmosphere; one end of the second communication valve 29 is in communication with the accommodating chamber of the second liquid tank 22 through a pipeline, and the other end thereof is in communication with the external atmosphere; and the negative pressure generating assembly 23 may be respectively in communication with the accommodating chamber of the first liquid tank 21 and the accommodating chamber of the second liquid tank 22 in an on-off manner.

The first communication valve 28 and the second communication valve 29 are disposed to ensure that the first liquid tank 21 and the second liquid tank 22 are in communication with the external atmosphere in an on-off manner, thereby providing structural and functional support for internal air pressure changes of the first liquid tank 21 and the second liquid tank 22.

As shown in Fig. 1, the basic circulating liquid supply device 10 further includes: a filter 13, an outlet pressure sensor 14, an outlet temperature sensor 15, a first solenoid valve 16, a first flow valve 17, a bypass branch 18, a second solenoid valve 181 and a second flow valve 182; an outlet of the heat exchanger 11, the circulation pump 12, the filter 13, the first flow valve 17, the outlet temperature sensor 15, the outlet pressure sensor 14, the first solenoid valve 16 and an inlet of the position 40 to be cooled are in communication in sequence through a pipeline; the outlet pressure sensor 14 is configured to detect a pressure of the coolant at an outlet of the pipeline to obtain an outlet pressure; the first solenoid valve 16 is configured to control a connection and disconnection of the pipeline of the basic circulating liquid supply device 10, and the first flow valve 17 is configured to regulate a flow of the pipeline of the basic circulating liquid supply device 10; the bypass branch 18 is disposed in parallel with the position 40 to be cooled, and is configured to shunt the position 40 to be cooled; the second solenoid valve 181 and the second flow valve 182 are disposed in the bypass branch 18 in sequence, the second solenoid valve 181 is configured to control a connection and disconnection of the bypass branch 18, and the second flow valve 182 is configured to regulate a flow of the bypass branch 18; and an outlet of the position 40 to be cooled is in communication with the switching assembly 30 and an inlet of the heat exchanger 11 through a pipeline, and the coolant flows circularly.

This arrangement not only ensures an operating reliability of the basic circulating liquid supply device, but also simplifies a structure of the basic circulating liquid supply device, and facilitating assembly and subsequent maintenance. By setting the bypass branch 18, the coolant shunting for the position 40 to be cooled is achieved, and flow control at the position 40 to be cooled is achieved.

As shown in Fig. 1, the heat exchanger 11 is internally provided with a basic circulation pipeline and a circulating heat exchange pipeline disposed at intervals, and the basic circulation pipeline is in communication with the circulation pump 12; the liquid-cooled circulating liquid supply system further includes a circulating heat exchange device 50, the circulating heat exchange device 50 includes a heat exchange source 51 configured to exchange heat with an external environment, an on-off valve 52 configured to control a connection and disconnection of the pipeline, a circulation filter 53, a first circulation temperature sensor 54 and a second circulation temperature sensor 55; one end of the heat exchange source 51, the first circulation temperature sensor 54, the on-off valve 52, and one end of the circulating heat exchange pipeline are in communication in sequence through a pipeline; the other end of the circulating heat exchange pipeline, the circulation filter 53, the second circulation temperature sensor 55, and the other end of the heat exchange source 51 are in communication in sequence through a pipeline; and the heat exchange source 51 exchanges heat with the basic circulation pipeline through the circulating heat exchange pipeline.

The circulating heat exchange device 50 is disposed to further improve a heat exchange efficiency between the heat exchanger 11 and the outside, and further improve an overall heat exchange effect of the liquid-cooled circulating liquid supply system.

In an embodiment, the liquid-cooled circulating liquid supply system further includes a central control terminal and an altitude sensor configured to detect an altitude of a position of the negative pressure circulating liquid supply device 20; the altitude sensor is electrically connected to the central control terminal; and the central control terminal calculates an external environmental atmospheric pressure based on the altitude detected by the altitude sensor; as shown in Fig. 1, the liquid-cooled circulating liquid supply system further includes an alarm and an outlet pressure sensor 14, wherein the alarm is electrically connected to the central control terminal and is configured to issue an alarm message; the outlet pressure sensor 14 is disposed at the outlet of the pipeline and is electrically connected to the central control terminal; the outlet pressure sensor 14 is configured to detect the outlet pressure; the circulation pump 12 and the negative pressure generating assembly 23 are respectively electrically connected to the central control terminal; and the central control terminal controls the circulation pump 12 and the negative pressure generating assembly 23 to operate in coordination based on the outlet pressure, the calculated external environmental atmospheric pressure and a set outlet pressure value.

By setting the central control terminal and the altitude sensor, the altitude of the position of the negative pressure circulating liquid supply device 20 is detected in real time, and a structural support is provided for the subsequent calculation of the external air pressure Po by the central control terminal; by arranging the alarm and the outlet pressure sensor 14, the outlet pressure is detected in real time, and the alarm may be issued in time when the system operates abnormally, thereby ensuring safety.

Some other embodiments of the present invention further provide a liquid-cooled circulating liquid supply method. The liquid-cooled circulating liquid supply method is applied to the above liquid-cooled circulating liquid supply system; the liquid-cooled circulating liquid supply method includes: a basic circulating liquid supply step: using the circulation pump 12 to drive the coolant to circulate and exchange heat under the positive pressure between the position 40 to be cooled and the heat exchanger 11; a negative pressure circulating liquid supply step: using the negative pressure generating assembly 23 and/or the circulation pump 12 to drive the coolant to circulate and exchange heat under the negative pressure along the pipeline between the position 40 to be cooled and the heat exchanger 11.

In the liquid-cooled circulating liquid supply method provided in the present invention, by setting the basic circulating liquid supply step and the negative pressure circulating liquid supply step, the basic circulating liquid supply device 10 is used as a conventional positive pressure CDU, and the basic circulating liquid supply device 10 and the negative pressure circulating liquid supply device 20 may also be used together as a negative pressure CDU.

As shown in Fig. 1, two liquid tanks are provided, namely, the first liquid tank 21 and the second liquid tank 22; the first liquid tank 21 and the second liquid tank 22 are respectively in communication with the negative pressure generating assembly 23 through a pipeline; the pressure in the first liquid tank 21 is the first negative pressure, and the pressure in the second liquid tank 22 is the second negative pressure; the negative pressure circulating liquid supply step further includes a negative pressure switching step: first controlling the first negative pressure to be less than the second negative pressure, and controlling the second negative pressure to be less than or equal to the external air pressure, such that the coolant enters the first liquid tank 21 from the second liquid tank 22; detecting a liquid level height in the first liquid tank 21, and in response to the liquid level height exceeding the set height, controlling the first negative pressure to be greater than the second negative pressure, and controlling the first negative pressure to be less than or equal to the external air pressure, such that the coolant enters the second liquid tank 22 from the first liquid tank 21.

This arrangement completes a method design of an operating process of the negative pressure system utilizing a pressure difference and ensures that the negative pressure circulating liquid supply device 20 operates reliably.

In an embodiment, the external air pressure Po is calculated by the following calculation formula: Po=P0* [1-(0.0065*H)/288.15] ^{5.255}, wherein P0 is a standard atmospheric pressure, and H is the altitude of the position of the negative pressure circulating liquid supply device 20.

By setting the above calculation formula and using the altitude of the position of the negative pressure circulating liquid supply device 20 as a variable, the external air pressure Po with higher accuracy is calculated, thereby providing a reference for the subsequent high-precision outlet pressure control.

In an embodiment, the liquid-cooled circulating liquid supply method further includes a hydraulic control step: detecting a pressure of the coolant at the outlet of the pipeline to obtain the outlet pressure, comparing the outlet pressure with the set outlet pressure value, and controlling the circulation pump 12 and/or the negative pressure generating assembly 23 to operate in coordination to regulate the outlet pressure.

By setting a hydraulic control step, the liquid-cooled circulating liquid supply system provided in the present invention has self-correction and self-regulation functions, such that the liquid-cooled circulating liquid supply system may regulate and control the coolant circulation pressure with higher precision.

In an embodiment, the hydraulic control step includes a self-adjusting correction factor control step and a closed-loop control step: comparing the outlet pressure with the set outlet pressure value, calculating to obtain an actual error, in response to an absolute value of the actual error being greater than the first error, performing the self-adjusting correction factor control step to regulate the outlet pressure; and in response to the absolute value of the actual error being less than the first error and greater than a second error, performing the closed-loop control step to regulate the outlet pressure.

By setting the self-adjusting correction factor control step and the closed-loop control step, a robustness of the liquid-cooled circulating liquid supply system is further improved. When the liquid-cooled circulating liquid supply system faces abnormal or changing internal pressure, it may maintain stable and good pressure control capabilities. A system with high robustness may maintain stable performance when facing abnormal situations and will not cause system crashes or performance degradation due to changes in coolant pressure or incorrect detection parameters.

It should be noted that, in order to ensure the robustness of the liquid-cooled circulating liquid supply system, sufficient testing and verification are usually required to obtain various correction parameters and empirical values to calibrate various parameters in the system and ensure that the system may maintain good performance under different circumstances. In addition, the method of the present invention may subsequently help to improve the robustness of the system through the design of appropriate algorithm formulas (such as specific calculation formulas of the self-adjusting correction factor control step and the closed-loop control step).

In an embodiment, the self-adjusting correction factor control step includes:
in response to | E | > Eb, setting U = -Ku [αE+(1-α) EC] , and
regulating powers of the circulation pump 12 and/or the negative pressure generating assembly 23 based on a magnitude of U, wherein E is the actual error, Eb is the first error, Ku is a proportional coefficient, α = (αₛ-α₀) | E | /N+α₀, 0<α₀<α<αₛ<1, and a domain of E, EC and U is set to (-N, ..., -1, 0, 1, ..., N), N = 20.

It should be noted that the first error Eb is flexibly selected based on empirical values of the staff and the accuracy required for the actual outlet pressure of the system; the proportional coefficient Ku is also set as an empirical value; and the same is true for the settings of α₀, α and αₛ.

In an embodiment, the closed-loop control step includes: in response to Ea < | E | < Eb, setting U = Kp [e(k)-e(k-1)] +Ki e(k)+Kd [e(k)-2e(k-1)+e(k-2)] , and
regulating powers of the circulation pump 12 and/or the negative pressure generating assembly 23 based on the magnitude of U, wherein Ea is the second error, E is the actual error, Eb is the first error, Kp is a proportional coefficient, Ki is an integral coefficient, Kd is a differential coefficient, and e(k) is the actual error at a k-th sampling.

It should be noted that in an embodiment of the present invention, the closed-loop control step adopts a logic of a PID control step; selections of the proportional coefficient Kp, the integral coefficient Ki, and the differential coefficient Kd usually need to be determined through debugging and optimization. Generally speaking, selections of these three coefficients need to consider factors such as the dynamic characteristics, stability, and response speed of the system.

The proportional coefficient Kp (i.e., P) is usually used to adjust a static error of the system. Its selection needs to be determined based on static characteristics of the system. If the static error of the system is large, the proportional coefficient needs to be increased to increase the control strength, otherwise the proportional coefficient needs to be reduced.

The integral coefficient Ki (i.e., I) is used to eliminate an integral error of the system and has a certain regulating effect on the static error and dynamic error of the system. The selection of the integral coefficient Ki needs to be determined based on dynamic characteristics and stability of the system. Generally speaking, if the integral error of the system is large or the system has a large static error, the integral coefficient needs to be increased.

The differential coefficient Kd (i.e., D) is used to suppress system oscillation and improve a response speed of the system. The selection of the differential coefficient needs to be determined based on dynamic characteristics and stability of the system. If the system oscillates or responds slowly, the differential coefficient needs to be increased.

In summary, in the actual use of the present invention, appropriate values of the proportional coefficient Kp, the integral coefficient Ki and the differential coefficient Kd need to be determined through specific experiments and debugging. These three coefficients may be adjusted by observing response characteristics and stability of the system to achieve a best control effect of the system. Meanwhile, some existing automatic adjustment algorithms may also be used to assist in determining the values of these three coefficients.

In an embodiment, the hydraulic control step further includes a repetition step: in response to the absolute value of the actual error being equal to the first error or less than or equal to the second error, and a previous step of the repetition step being a self-adjusting correction factor control step or a closed-loop control step, repeating the step before the repetition step to regulate the outlet pressure; in response to the self-adjusting correction factor control step and the closed-loop control step being not performed before the repetition step, maintaining a current state. By setting the repetition step, excessive system switching caused by frequent changes in control strategies is effectively prevented, i.e., frequent system switching between the self-adjusting correction factor control step and the closed-loop control step is avoided. When the absolute value of the actual error is equal to the first error or less than or equal to the second error, the system does not switch steps and may maintain the previous action or the current state, thereby ensuring the operational stability of the system.

In an embodiment, in response to the previous step of the repetition step being a self-adjusting correction factor control step or a closed-loop control step, and | E | = Eb or | E | ≤Ea, setting U = u0, wherein Ea is the second error, E is the actual error, Eb is the first error, and u0 is the self-adjusting correction factor control step or the closed-loop control step before the repetition step.

In an embodiment of the present invention, the outlet pressure is regulated by the circulation pump 12, the first solenoid valve 16 and the first flow valve 17; and a detailed process of the control method is as follows:
Step 1: obtaining the set outlet pressure value P1;
Step 2: obtaining the outlet pressure P2 detected by the outlet pressure sensor 14 in real time;
Step 3: comparing P1 with P2; in response to the pressure difference between P1 and P2 being within 5 kPa, adjusting an opening of the first flow valve 17; in response to P1 being equal to P2, maintaining the opening of the first flow valve 17 unchanged, and returning to step 1 after waiting for 3 seconds; in response to P1 being greater than P2, adjusting the opening of the first flow valve 17 to be reduced by 0.5%, and then comparing P1 with P2; in response to the outlet pressure P2 being equal to the set outlet pressure value P1, then completing the adjustment, and returning to step 1 after waiting for 3 seconds, otherwise returning to step 3; in response to P1 being less than P2, adjusting the opening of the first flow valve 17 to be increased by 0.5%, and then comparing P1 with P2; in response to the outlet pressure P2 being equal to the set outlet pressure value P1, completing the adjustment, and returning to step 1 after waiting for 3 seconds, otherwise returning to step 3;
Step 4: in response to the pressure difference between P1 and P2 being above 5 kPa, adjusting a rotational speed of the circulation pump 12 to regulate the outlet pressure P2; in response to P1 being greater than P2, reducing the rotational speed of the circulation pump 12 by 2%, and then comparing P1 with P2; in response to the outlet pressure P2 being equal to the set outlet pressure value P1, then completing the adjustment, and returning to step 1 after waiting for 3 seconds, otherwise returning to step 3; in response to P1 being less than P2, increasing the rotational speed of the circulation pump 12 by 2%, and then comparing P1 with P2; in response to the outlet pressure P2 being equal to the set outlet pressure value P1, completing the adjustment, and returning to step 1 after waiting for 3 seconds, otherwise returning to step 3.

In an embodiment, the liquid-cooled circulating liquid supply method further includes a fault control step: in response to a fault being detected in the negative pressure circulating liquid supply device 20, issuing an alarm message, and switching the liquid-cooled circulating liquid supply system to operate in the basic circulation mode; in response to the fault being detected in the circulation pump 12 in the basic circulating liquid supply device 10, issuing the alarm message, and switching the liquid-cooled circulating liquid supply system to operate in the negative pressure circulation mode.

In an embodiment of the present invention, when a component in the negative pressure circulating liquid supply device 20 or the basic circulating liquid supply device 10 fails, the system operates in the following steps:
1. In response to the negative pressure circulating liquid supply device 20 failing, the system will issue an alarm through the alarm to prompt the operation and maintenance personnel to perform maintenance. The first switch valve 31 is open, the second switch valve 32, the third switch valve 33, the fourth switch valve 34 and the fifth switch valve 35 are closed, and the system operates as a positive pressure CDU system.
2. In response to the circulation pump 12 in the basic circulating liquid supply device 10 failing, the system alarms and prompts the operation and maintenance personnel to perform maintenance; the system still operates in a cooperative working mode with either the negative pressure circulating liquid supply device 20 or the basic circulating liquid supply device 10 (e.g., the negative pressure circulation mode), and the outlet pressure is regulated based on the first solenoid valve 16 and the first flow valve 17.

In summary, the present invention provides a liquid-cooled circulating liquid supply system and a liquid-cooled circulating liquid supply method. The present invention creates a combined liquid-cooled circulating liquid supply system by arranging the basic circulating liquid supply device 10 and the negative pressure circulating liquid supply device 20 to operate in coordination. In the present invention, by the switching assembly 30, the basic circulating liquid supply device 10 may be used alone as a conventional positive pressure CDU, or the basic circulating liquid supply device 10 and the negative pressure circulating liquid supply device 20 may be used in coordination as a negative pressure CDU; the basic circulating liquid supply device 10 and the negative pressure circulating liquid supply device 20 may be maintained separately. The system complexity of the present invention is low, and the maintenance difficulty is greatly reduced. In response to one of the basic circulating liquid supply device 10 and the negative pressure circulating liquid supply device 20 fails, the liquid-cooled circulating liquid supply system may still operate normally, thereby improving the operating reliability of the system. The present invention may greatly reduce the difficulty of system maintenance and installation deployment, reduce operation and maintenance costs, and is suitable for large-scale promotion and use. The liquid-cooled circulating liquid supply system provided in the present invention may subsequently be combined with a related liquid-cooled circulating liquid supply method, which may not only effectively solve the problem that the related negative pressure liquid cooling system is usually unable to regulate the pressure, but also improve the dynamic response speed of the system to the coolant outlet pressure by adopting a self-adjusting correction factor control step and a closed-loop control step. The liquid-cooled circulating liquid supply system has good use effect and high safety, and may effectively avoid the problem of coolant leakage.

It should be noted that the terms used herein are merely for describing specific embodiments and are not intended to limit the exemplary embodiments according to the present invention. As used herein, unless the context clearly indicates otherwise, the singular form is also intended to include the plural form. In addition, it should be understood that when the terms "comprise" and/or "include" are used in this specification, they indicate the presence of features, steps, operations, devices, components and/or combinations thereof.

Unless otherwise specified, the relative arrangement of the parts and steps, numerical expressions and numerical values set forth in these embodiments do not limit the scope of the present invention. Meanwhile, it should be understood that, for ease of description, the sizes of the various parts shown in the accompanying drawings are not drawn according to actual proportional relationships. Technology, methods and devices known to those skilled in the relevant art may not be discussed in detail, but in appropriate cases, the technology, methods and devices should be considered as a part of the specification. In all the examples shown and discussed herein, any specific value should be interpreted as being merely exemplary, rather than as a limitation. Therefore, other examples of exemplary embodiments can have different values. It should be noted that similar numbers and letters represent similar items in the following drawings. Therefore, once an item is defined in an accompanying drawing, it does not need to be further discussed in subsequent drawings.

In the description of the present invention, it should be understood that the directional or positional relationships indicated by directional words such as "front, back, up, down, left, right", "lateral, longitudinal, vertical, horizontal" and "top, bottom" are usually based on the directional or positional relationships shown in the accompanying drawings. They are merely for the convenience of describing the present invention and simplifying the description. Unless otherwise specified, these directional words do not indicate or imply that the device or element referred to must have a specific direction or must be constructed and operated in a specific direction. Therefore, they cannot be understood as limiting the protection scope of the present invention. The directional words "inside and outside" refer to the inside and outside relative to the contour of each component itself.

For ease of description, spatially relative terms such as "on", "above", "on the upper surface of", "upper" and the like may be used herein to describe the spatial positional relationship of a device or feature to other devices or features as shown in the drawings. It should be understood that spatially relative terms are intended to include different orientations of the device in use or operation in addition to the orientation described in the drawings. For example, if the device in the drawings is inverted, the device described as "above other devices or structures" or "on other devices or structures" will be positioned as "below other devices or structures" or "under other devices or structures". Therefore, the exemplary term "above" can include both "above" and "below". The device can also be positioned in other different ways (rotated by 90 degrees or in other orientations), and the spatially relative descriptions used herein are interpreted accordingly.

In addition, it should be noted that the use of terms such as "first" and "second" to limit components is only for the convenience of distinguishing the corresponding components. Unless otherwise stated, the above terms have no special meaning and therefore cannot be understood as limiting the protection scope of the present invention.

The above description is merely a preferred embodiment of the present invention and is not intended to limit the present invention. For those skilled in the art, various modifications and variations can be made to the present invention. Any modifications, equivalent substitutions, or improvements made within the spirit and principles of the present invention shall be included within the protection scope of the present invention.

## Claims

1. A liquid-cooled circulating liquid supply system, comprising:
a basic circulating liquid supply device (10), wherein the basic circulating liquid supply device (10) comprises a heat exchanger (11) and a circulation pump (12) communicated through a pipeline;
a negative pressure circulating liquid supply device (20), wherein the negative pressure circulating liquid supply device (20) comprises a liquid tank and a negative pressure generating assembly (23) communicated through a pipeline, and the negative pressure generating assembly (23) is configured to regulate a pressure in an accommodating chamber inside the liquid tank to a negative pressure;
a switching assembly (30), wherein the switching assembly (30) is configured to control a connection and disconnection between the basic circulating liquid supply device (10) and the negative pressure circulating liquid supply device (20);
wherein the liquid-cooled circulating liquid supply system has a basic circulation mode and a negative pressure circulation mode; in the basic circulation mode, the switching assembly (30) disconnects a communication between the basic circulating liquid supply device (10) and the negative pressure circulating liquid supply device (20), and the circulation pump (12) drives a coolant to circulate and exchange heat under a positive pressure along a pipeline between a position (40) to be cooled and the heat exchanger (11); in the negative pressure circulation mode, the switching assembly (30) establishes the communication between the basic circulating liquid supply device (10) and the negative pressure circulating liquid supply device (20), and the negative pressure generating assembly (23) drives the coolant to circulate and exchange heat under a negative pressure along the pipeline between the position (40) to be cooled and the heat exchanger (11).

2. The liquid-cooled circulating liquid supply system as claimed in claim 1, wherein in the negative pressure circulation mode, the negative pressure generating assembly (23) and the circulation pump (12) simultaneously drive the coolant to circulate and exchange heat under the negative pressure along the pipeline between the position to be cooled (40) and the heat exchanger (11).

3. The liquid-cooled circulating liquid supply system as claimed in claim 1, wherein two liquid tanks are provided, namely, a first liquid tank (21) and a second liquid tank (22); the first liquid tank (21) and the second liquid tank (22) are respectively in communication with the negative pressure generating assembly (23) through the pipeline; and a reciprocating flow of the coolant is controlled by controlling changes in a pressure in the first liquid tank (21) and a pressure in the second liquid tank (22).

4. The liquid-cooled circulating liquid supply system as claimed in claim 3, wherein the pressure in the first liquid tank (21) is a first negative pressure, and the pressure in the second liquid tank (22) is a second negative pressure; in response to a liquid level height in the first liquid tank (21) not exceeding a set height, the first negative pressure is less than the second negative pressure, and the second negative pressure is less than or equal to an external air pressure; the heat exchanger (11) and the position (40) to be cooled are in communication between the first liquid tank (21) and the second liquid tank (22) through pipelines; and the coolant enters the first liquid tank (21) from the second liquid tank (22) through a pressure difference between the first negative pressure and the second negative pressure.

5. The liquid-cooled circulating liquid supply system as claimed in claim 4, wherein the negative pressure circulating liquid supply device (20) further comprises a liquid level gauge, and the liquid level gauge is configured to detect a liquid level height of the coolant in the accommodating chamber; in response to the liquid level gauge detecting that the liquid level height in the first liquid tank (21) exceeds the set height, the first negative pressure is controlled to be greater than the second negative pressure, and the first negative pressure is controlled to be less than or equal to the external air pressure, and the coolant enters the second liquid tank (22) from the first liquid tank (21).

6. The liquid-cooled circulating liquid supply system as claimed in claim 5, wherein the switching assembly (30) comprises a first switch valve (31), a second switch valve (32), a third switch valve (33), a fourth switch valve (34) and a fifth switch valve (35); the first switch valve (31) is disposed in a circulation pipeline in the basic circulating liquid supply device (10) and is configured to control a connection and disconnection of the circulation pipeline of the basic circulating liquid supply device (10); the negative pressure circulating liquid supply device (20) further comprises a first input pipe (24), a first output pipe (25), a second input pipe (26) and a second output pipe (27); one end of the first input pipe (24) and one end of the first output pipe (25) are respectively in communication with the first liquid tank (21); the second switch valve (32) is disposed in the first input pipe (24); the third switch valve (33) is disposed in the first output pipe (25); one end of the second input pipe (26) and one end of the second output pipe (27) are respectively in communication with the second liquid tank (22); the fourth switch valve (34) is disposed in the second input pipe (26), and the fifth switch valve (35) is disposed in the second output pipe (27); the other end of the first input pipe (24) and the other end of the second input pipe (26) are respectively in communication with a pipeline at one end of the first switch valve (31), and the other end of the first output pipe (25) and the other end of the second output pipe (27) are respectively in communication with a pipeline at the other end of the first switch valve (31);
in the basic circulation mode, the second switch valve (32), the third switch valve (33), the fourth switch valve (34) and the fifth switch valve (35) are all in a closed state, and the first switch valve (31) is open, and the communication between the basic circulating liquid supply device (10) and the negative pressure circulating liquid supply device (20) is disconnected.

7. The liquid-cooled circulating liquid supply system as claimed in claim 6, wherein
in the negative pressure circulation mode, the first negative pressure is less than the second negative pressure, and the second negative pressure is less than or equal to the external air pressure; the second switch valve (32) and the fifth switch valve (35) are in an open state, and the first switch valve (31), the third switch valve (33) and the fourth switch valve (34) are in a closed state; the coolant enters the pipeline at the other end of the first switch valve (31) from the second liquid tank (22) and the second output pipe (27), and passes through the heat exchanger (11), the position (40) to be cooled, the pipeline at one end of the first switch valve (31) and the first input pipe (24) in sequence and enters the first liquid tank (21); or
in the negative pressure circulation mode, the first negative pressure is greater than the second negative pressure, and the first negative pressure is less than or equal to the external air pressure; the third switch valve (33) and the fourth switch valve (34) are in an open state, and the first switch valve (31), the second switch valve (32) and the fifth switch valve (35) are in a closed state; the coolant enters the pipeline at the other end of the first switch valve (31) from the first liquid tank (21) and the first output pipe (25), and passes through the heat exchanger (11), the position to be cooled (40), the pipeline at one end of the first switch valve (31) and the second input pipe (26) in sequence and enters the second liquid tank (22).

8. The liquid-cooled circulating liquid supply system as claimed in claim 3, wherein the negative pressure circulating liquid supply device (20) further comprises a first communication valve (28) and a second communication valve (29), one end of the first communication valve (28) is in communication with the accommodating chamber of the first liquid tank (21) through a pipeline, and the other end thereof is in communication with an external atmosphere; one end of the second communication valve (29) is in communication with the accommodating chamber of the second liquid tank (22) through a pipeline, and the other end thereof is in communication with the external atmosphere; and the negative pressure generating assembly (23) is respectively in communication with the accommodating chamber of the first liquid tank (21) and the accommodating chamber of the second liquid tank (22) in an on-off manner.

9. The liquid-cooled circulating liquid supply system as claimed in claim 1, wherein the basic circulating liquid supply device (10) further comprises: a filter (13), an outlet pressure sensor (14), an outlet temperature sensor (15), a first solenoid valve (16), a first flow valve (17), a bypass branch (18), a second solenoid valve (181) and a second flow valve (182); an outlet of the heat exchanger (11), the circulation pump (12), the filter (13), the first flow valve (17), the outlet temperature sensor (15), the outlet pressure sensor (14), the first solenoid valve (16) and an inlet of the position (40) to be cooled are in communication in sequence through a pipeline; the outlet pressure sensor (14) is configured to detect a pressure of the coolant at an outlet of the pipeline to obtain an outlet pressure; the first solenoid valve (16) is configured to control a connection and disconnection of the pipeline of the basic circulating liquid supply device (10), and the first flow valve (17) is configured to regulate a flow of the pipeline of the basic circulating liquid supply device (10); the bypass branch (18) is disposed in parallel with the position (40) to be cooled and is configured to shunt the position (40) to be cooled; the second solenoid valve (181) and the second flow valve (182) are disposed in the bypass branch (18) in sequence, the second solenoid valve (181) is configured to control a connection and disconnection of the bypass branch (18), and the second flow valve (182) is configured to regulate a flow of the bypass branch (18); and an outlet of the position (40) to be cooled is in communication with the switching assembly (30) and an inlet of the heat exchanger (11) through a pipeline, and the coolant flows circularly.

10. The liquid-cooled circulating liquid supply system as claimed in claim 1, wherein the heat exchanger (11) is internally provided with a basic circulation pipeline and a circulating heat exchange pipeline disposed at intervals, and the basic circulation pipeline is in communication with the circulation pump (12); the liquid-cooled circulating liquid supply system further comprises a circulating heat exchange device (50), the circulating heat exchange device (50) comprises a heat exchange source (51) configured to exchange heat with an external environment, an on-off valve (52) configured to control a connection and disconnection of a pipeline, a circulation filter (53), a first circulation temperature sensor (54) and a second circulation temperature sensor (55), one end of the heat exchange source (51), the first circulation temperature sensor (54), the on-off valve (52), and one end of the circulating heat exchange pipeline are in communication in sequence through a pipeline; the other end of the circulating heat exchange pipeline, the circulation filter (53), the second circulation temperature sensor (55), and the other end of the heat exchange source (51) are in communication in sequence through a pipeline; and the heat exchange source (51) exchanges heat with the basic circulation pipeline through the circulating heat exchange pipeline.

11. The liquid-cooled circulating liquid supply system as claimed in claim 1, wherein the liquid-cooled circulating liquid supply system further comprises a central control terminal and an altitude sensor configured to detect an altitude of a position of the negative pressure circulating liquid supply device (20); the altitude sensor is electrically connected to the central control terminal; and the central control terminal calculates an external ambient atmospheric pressure based on the altitude detected by the altitude sensor;
the liquid-cooled circulating liquid supply system further comprises an alarm and an outlet pressure sensor (14), the alarm is electrically connected to the central control terminal and is configured to issue an alarm message; the outlet pressure sensor (14) is disposed at an outlet of the pipeline and is electrically connected to the central control terminal; the outlet pressure sensor (14) is configured to detect an outlet pressure; the circulation pump (12) and the negative pressure generating assembly (23) are electrically connected to the central control terminal respectively; and the central control terminal controls the circulation pump (12) and the negative pressure generating assembly (23) to operate in coordination based on the outlet pressure, the calculated external ambient atmospheric pressure and a set outlet pressure value.

12. A liquid-cooled circulating liquid supply method, applied to the liquid-cooled circulating liquid supply system as claimed in any one of claims 1 to 11, comprising:
a basic circulating liquid supply step: using the circulation pump (12) to drive the coolant to circulate and exchange heat under the positive pressure between the position (40) to be cooled and the heat exchanger (11); and
a negative pressure circulating liquid supply step: using the negative pressure generating assembly (23) and/or the circulation pump (12) to drive the coolant to circulate and exchange heat under the negative pressure along the pipeline between the position (40) to be cooled and the heat exchanger (11).

13. The liquid-cooled circulating liquid supply method as claimed in claim 12, wherein two liquid tanks are provided, namely, a first liquid tank (21) and a second liquid tank (22); the first liquid tank (21) and the second liquid tank (22) are respectively in communication with the negative pressure generating assembly (23) through a pipeline; a pressure in the first liquid tank (21) is a first negative pressure, and a pressure in the second liquid tank (22) is a second negative pressure; the negative pressure circulating liquid supply step further comprises a negative pressure switching step: first controlling the first negative pressure to be less than the second negative pressure, and controlling the second negative pressure to be less than or equal to an external air pressure, such that the coolant enters the first liquid tank (21) from the second liquid tank (22); detecting a liquid level height in the first liquid tank (21), and in response to the liquid level height exceeding a set height, controlling the first negative pressure to be greater than the second negative pressure, and controlling the first negative pressure to be less than or equal to the external air pressure, such that the coolant enters the second liquid tank (22) from the first liquid tank (21).

14. The liquid-cooled circulating liquid supply method as claimed in claim 13, wherein the external air pressure Po is calculated by the following calculation formula: Po=P0*[1-(0.0065*H)/288.15]^{5.255}; where P0 is a standard atmospheric pressure, and H is an altitude of a position of the negative pressure circulating liquid supply device (20).

15. The liquid-cooled circulating liquid supply method as claimed in claim 12, wherein the liquid-cooled circulating liquid supply method further comprises a hydraulic control step: detecting a pressure of the coolant at an outlet of the pipeline to obtain an outlet pressure, comparing the outlet pressure with a set outlet pressure value, and controlling the circulation pump (12) and/or the negative pressure generating assembly (23) to operate in coordination to regulate the outlet pressure.

16. The liquid-cooled circulating liquid supply method as claimed in claim 15, wherein the hydraulic control step comprises a self-adjusting correction factor control step and a closed-loop control step: comparing the outlet pressure with the set outlet pressure value, calculating to obtain an actual error, in response to an absolute value of the actual error being greater than a first error, performing the self-adjusting correction factor control step to regulate the outlet pressure; and in response to the absolute value of the actual error being less than the first error and greater than a second error, performing the closed-loop control step to regulate the outlet pressure.

17. The liquid-cooled circulating liquid supply method as claimed in claim 16, wherein the self-adjusting correction factor control step comprises: in response to | E | >Eb, setting U=-Ku [αE+(1-α) EC], and regulating powers of the circulation pump (12) and/or the negative pressure generating assembly (23) based on a magnitude of U; where E is the actual error, Eb is the first error, Ku is a proportional coefficient, α=(αₛ-α₀) | E | /N+α₀, 0<α₀<α<αₛ<1, and a domain of E, EC and U is set to (-N, ..., -1, 0, 1, ..., N), N=20.

18. The liquid-cooled circulating liquid supply method as claimed in claim 16, wherein the closed-loop control step comprises: in response to Ea< | E | <Eb, setting U = Kp [e(k)-e(k-1)] +Ki e(k)+Kd [e(k)-2e(k-1)+e(k-2)] , and regulating powers of the circulation pump (12) and/or the negative pressure generating assembly (23) based on a magnitude of U; where Ea is the second error, E is the actual error, Eb is the first error, Kp is a proportional coefficient, Ki is an integral coefficient, Kd is a differential coefficient, and e(k) is the actual error at a k-th sampling.

19. The liquid-cooled circulating liquid supply method as claimed in claim 16, wherein the hydraulic control step further comprises a repetition step: in response to the absolute value of the actual error being equal to the first error or less than or equal to the second error, and a previous step of the repetition step being the self-adjusting correction factor control step or the closed-loop control step, repeating the step before the repetition step to regulate the outlet pressure; in response to the self-adjusting correction factor control step and the closed-loop control step being not performed before the repetition step, maintaining a current state.

20. The liquid-cooled circulating liquid supply method as claimed in claim 19, wherein in response to the previous step of the repetition step being the self-adjusting correction factor control step or the closed-loop control step, and | E | =Eb or | E | ≤Ea, setting U=u0, where Ea is the second error, E is the actual error, Eb is the first error, and u0 is the self-adjusting correction factor control step or the closed-loop control step before the repetition step.

21. The liquid-cooled circulating liquid supply method as claimed in claim 12, wherein the liquid-cooled circulating liquid supply method further comprises a fault control step: in response to a fault being detected in the negative pressure circulating liquid supply device (20), issuing an alarm message, and switching the liquid-cooled circulating liquid supply system to operate in the basic circulation mode; in response to a fault being detected in the circulation pump (12) in the basic circulating liquid supply device (10), issuing the alarm message, and switching the liquid-cooled circulating liquid supply system to operate in the negative pressure circulation mode.
